# EUROPÄISCHE PATENTSCHRIFT

(11) **EP 1 414 066 B1**
(45) Veröffentlichungstag und Bekanntmachung des Hinweises auf die Patenterteilung: **29.07.2009**
(21) Anmeldenummer: 03023086.6
(22) Anmeldetag: 15.10.2003
(51) Int. Cl.: H01L 25/07, G01R 31/316, G01R 31/28, G01R 31/04, G01R 31/27, H01L 23/498, H01L 23/544, H01L 25/16

(54) **Verfahren zur Überwachung von Leistungshalbleiterbauelementen**
Method for monitoring semiconductor power elements
Procédé pour contrôler des dispositifs semiconducteurs de puissance

(30) Priorität: 25.10.2002 DE 10249712; 10.04.2003 DE 10316357
(43) Veröffentlichungstag der Anmeldung: 28.04.2004
(73) Patentinhaber: SEMIKRON Elektronik GmbH & Co. KG, 90431 Nürnberg (DE)
(72) Erfinder: Herzer, Reinhrad, Dr., 98693 Ilmenau (DE); Netzel, Mario, Dr., 98693 Ilmenau (DE); Lehmann, Jan, 98693 Ilmenau (DE); Pawel, Sascha, 99867 Gotha (DE)

(56) Entgegenhaltungen:
- EP-A- 1 028 465
- DE-A- 10 005 754
- US-A1- 2001 019 169
- US-A1- 2002 024 135

## Beschreibung

Die Erfindung beschreibt für eine Schaltungsanordnung ein Verfahren zur Überwachung des Kontakts von Drahtbond- oder anderer elektrisch leitender Verbindungen mit Leistungshalbleiterbauelementen, insbesondere bei IGBT- und MOSFET-Leistungshalbleiterschaltern,

Nach dem Stand der Technik sind beispielhaft Drahtbondverbindungen, Lotverbindungen, auch Lotbälle (solder balls) als elektrisch leitende Verbindungen zwischen Substraten und Leistungshalbleiterbauelemente bekannt. Sie gewährleisten die elektrische Verbindung zwischen einem Leistungshalbleiterbauelement und einem Substrat, z.B. einer nach dem direct-copper-bonding hergestellten meist beidseitig kupferkaschierten Keramik (kurz: DCB-Substrat), innerhalb eines Leistungshalbleiter-Moduls, bzw. den Anschluss- Pins (kurz: leadframe) eines diskreten Gehäuses

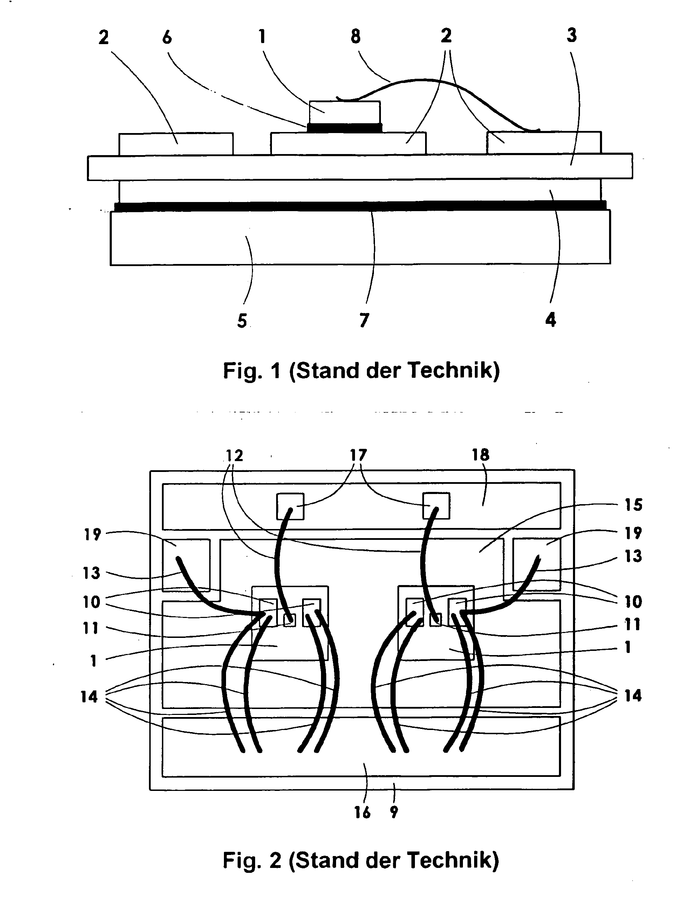

In den Fig. 1 und 2 wird der Stand der Technik beispielhaft anhand eines Leistungshalbleitermoduls dargestellt. In Fig. 1 sind der prinzipielle Aufbau eines Leistungshalbleitermoduls im Querschnitt sowie gängige Verbindungstechniken gezeigt. Dargestellt ist ein Leistungshalbleiterbauelement (1), die diesem zugewandte und in sich strukturierte erste Kupferfläche (2) des DCB- Substrats, die elektrisch isolierende Keramik (3), die einer Grundplatte oder einem Kühlkörper zugewandte zweite Kupferfläche (4) des DCB- Substrats, die Bodenplatte bzw. der Kühlkörper (5), die Lotverbindung (6) zwischen Leistungshalbleiterbauelement (1) und erster Kupferfläche (2), die Zwischenschicht (7) zwischen zweiter Kupferfläche (4) und Grundplatte oder Kühlkörper (5) und eine Drahtbondverbindung (8) zwischen dem Leistungshalbleiterbauelement und der Kupferfläche (2) des DCB- Substrats. Hierbei ist die Zwischenschicht (7) entweder eine stoffschlüssige Lotverbindung oder eine stoffbündige, wärmeleitende, Schicht. Der Rückseitenkontakt des Leistungshalbleiterbauelements (auf der dem Substrat zugewandten Seite), beispielhaft der Kollektor im Falle eines IGBT als Leistungshalbleiterbauelement (1), mit der ersten Kupferfläche (2), kann mittels einer Lötung (6) realisiert werden. Die vorderseitigen Anschlüsse des Leistungshalbleiterbauelements, beispielhaft das Gate und der Emitter eines IGBT, werden vorzugsweise mittels Drahtbondverbindungen (8) mit jeweils einem oder mehreren zum Teil voneinander isolierten Anschlussgebieten der ersten Kupferfläche (2) des DCB- Substrats verbunden. Der mit Hilfe des Leistungshalbleiterbauelements zu schaltende Strom durchfließt sowohl die großflächige Lotverbindung (6) an der Rückseite des Leistungshalbleiterbauelements, als auch die Drahtbondverbindungen des Emitters (8) an der Vorderseite des Leistungshalbleiterbauelements. Eine auch nur teilweise Zerstörung einer der beiden Verbindungstechniken führt zwangsläufig zum Verlust der Stromtragfähigkeit und folglich zu dessen Ausfall. Der Ausfall ist hierbei häufig nicht durch elektrische Vorgänge verursacht, sondern durch weitere Vorgänge wie beispielhaft mechanische Beanspruchung oder Veränderungen der Werkstoffeigenschaften in Folge thermischer Wechselbelastungen.

Fig. 2 zeigt beispielhaft eine mögliche Strukturierung eines DCB- Substrats (9) nach dem Stand der Technik mit den erforderlichen Drahtbondverbindungen und zwei parallel geschalteten Leistungshalbleiterbauelementen (1) aufgelötet auf einer gemeinsamen Leiterfläche (15), wobei diese Fläche den Hauptstrom des Bauelements führt (Im Falle eines IGBTs ist dies der Kollektor). Die Anschlüsse der Leistungshalbleiterbauelemente auf der dem Substrat abgewandten Seite erfolgt über Kontaktflächen auf dessen Oberfläche. Diese werden auch als Bondpads bezeichnet, die unterschiedliche Funktion besitzen. Zum einen führen sie den Hauptstrom und stellen den Bezugsknoten für die Ansteuerschaltung dar. Im Falle eines IGBT werden diese als Emitterbondpad (10) bezeichnet. Zum anderen dienen sie der Steuerung des Leistungshalbleiterbauelements, beispielhaft im Falle eines IGBT als Gatepad (11) bezeichnet. Die Verbindungen zu den isolierten Kupferflächen (16, 18, 19) des DCB- Substrats werden mittels Drahtbondverbindungen (12, 13, 14) realisiert. Die Bonddrähte besitzen dabei ebenfalls unterschiedliche Funktionen. Die zum Führen des Hauptstromes notwendigen Bonddrähte werden als Emitterbonddrähte (14) bezeichnet, die zur Ansteuerung notwendigen Bonddrähte als Gatebonddraht (12), die Verbindung zum Bezugsknoten als Hilfsemitterbonddraht (13). Der Hilfsemitterbonddraht (13) kann beispielhaft als Verlängerung eines Emitterbonddrahtes (14) ausgebildet, wobei der Hilfsemitterbonddraht (13) gegenüber einem Emitterbonddraht (14) die Besonderheit besitzt, nicht vom Hauptstrom durchflossen zu werden. Damit werden Gegenkoppeleffekte im Ansteuerstromkreis infolge des Stromflusses im Hauptstromkreis minimiert. Bei Parallelschaltung mehrerer IGBTs ist es auch üblich das Hilfsemitterpotential an der Emittersammelschiene (16) abzugreifen und auf den Hilfsemitterbonddraht zu verzichten.

Die Gatebonddrähte (12) verbinden die Gatebondpads (11) mit den Gatevorwiderständen (17), die auf der Gatesammelschiene (18) angeordnet sind. Nach dem Stand der Technik können die Gatewiderstände (17) auch in das Leistungshalbleiterbauelement integriert werden, dann werden die Gatebondpads (11) direkt mit der Gatesammelschiene (18) verbunden.

Das Ablösen eines Emitterbonddrahtes (14) bewirkt eine Unterbrechung des Stromflusses über den abgelösten Bonddraht. Infolgedessen teilt sich der Strom auf die übrigen Emitterbonddrähte auf. Das führt zu einer steigenden Belastung und erhöhten Ausfallwahrscheinlichkeit der bisher intakten Emitterbonddrähte (14). In Folge lösen sich weitere Emitterbonddrähte (14) ab, bis keinerlei Verbindung von der Emittersammelschiene (16) zu den Emitterbondpads (10) des Halbleiterbauelements mehr besteht.

In Leistungshalbleitermodulen höherer Leistung sind in der Regel mehrere Leistungshalbleiterbauelemente parallel geschaltet. Im Falle des Ausfalls aller Emitterbonddrähte eines Chips kommt es dann in der Regel zum sofortigen Ausfall des Moduls. Falls das Modul nicht sofort ausfällt erhöht sich die Belastung der noch intakten Leistungshalbleiterbauelemente, was wiederum deren Lebensdauer vermindert. In weiterer Folge lösen sich von weiteren Leistungshalbleiterbauelementen die Bonddrähte ab, bis es zur Zerstörung aller Leistungshalbleiterbauelemente infolge elektrischer oder thermischer Überlastung kommt.

Nach dem Stand der Technik sind Ausfallindikatoren für Leistungsmodule zu Diagnosezwecken und zur Ausfallfrüherkennung bekannt. So bewirkt eine sich lösende Chiplötung wie auch sich ablösende Bonddrähte eine Erhöhung der Flussspannung der Leistungshalbleiter im eingeschalteten Zustand bzw. eine Zunahme des thermischen Widerstandes. Diese Größen sind allerdings im Betrieb nicht zugänglich.

In US 2001/0019169 A1 werden Widerstände innerhalb des Moduls zwischen getrennt herausgeführte Hauptanschlüsse geschaltet, um den elektrischen Kontakt zwischen Anschlusspin und Bondkontakt eines Leistungsbauelementes über die sich ergebenden Widerstandverhältnisse zu testen

In US 2002/0024135 A1 werden verschiedene Querverbindungen zwischen parallel geschalteten Leistungsbauelementen beschrieben, um über die unterschiedliche Verkopplung mittels unterschiedlicher Induktivitäten eine hohe Symmetrie beim Schalten der parallel geschalteten Leistungsbauelemente zu erreichen und letztlich Schwingungen zu vermeiden. Die Querverbindungen werden durch Bonddrähte direkt zwischen den Bauelementen sowie indirekt über Bondflächen auf dem Leadframe oder einem Substrat realisiert. Die Bonddrähte sowie die Bondflächen stellen dabei elektrisch gesehen verschiedene Induktivitäten zwischen den Bauelementen dar. Alle Maßnahmen zielen auf eine bessere Verkopplung der parallelgeschalteten Bauelemente innerhalb des Moduls zur Vermeidung von Oszillationen beim Schalten ab.

Auch sind beispielhaft aus der EP 0 752 593 A2 Verfahren bekannt, die eine Wechselspannung einer bestimmten Frequenz über eine Drahtbondverbindung leiten und aus einer Messung und Analyse der entstehenden Oberwellen auf defekte Bondverbindungen schließen. Diese Verfahren sind allerdings bisher nur als Sondermessungen außerhalb des Betriebes möglich.

Weiterhin sind Vorrichtungen zur Detektion des Bonddrahtabhebens auf der Grundlage einer mechanischen Auswertung bekannt. Dabei wird die Haftung der Bondverbindungen über Federkräfte gemessen. Eine Zuverlässigkeitserhöhung lässt sich allerdings nur mit hohem technischen Aufwand, hohen Kosten und dafür benötigtem Volumen erreichen. Auch dieses Verfahren ist, wie alle bisher genannten, nur als Laboraufbau bekannt.

Die vorliegende Erfindung hat die Aufgabe für eine Schaltungsanordnung ein Verfahren vorzustellen, um den Kontaktausfall von elektrisch leitenden Verbindungen, speziell Drahtbondverbindungen, einer Kontaktfläche eines Halbleiterbauelements oder einer Gruppe von elektrisch leitend verbundenen Kontaktflächen eines Halbleiterbauelements zu einer weiteren Kontaktfläche außerhalb des Halbleiterbauelements, beispielhaft auf dem Substrat, der durch die teilweise oder vollständige Unterbrechung dieser elektrisch leitenden Verbindung entsteht, während des Betriebs zu detektieren.

Diese Aufgabe wird gelöst durch die Maßnahmen gemäß dem Kennzeichen des Anspruchs 1. Weitere vorteilhafte Ausgestaltungen sind in den Unteransprüchen genannt.

Der grundlegende erfinderische Gedanke geht aus von einer Schaltungsanordnung bestehend aus mindestens einem Leistungshalbleiterbauelement und mindestens zwei voneinander elektrisch getrennten Kontaktflächen gleicher Funktionalität und / oder elektrisch getrennten Gruppen von Kontaktflächen gleicher Funktionalität. Jedes Leistungshalbleiterbauelement weist mindestens eine derartige Kontaktfläche auf. Unter einer Gruppe von Kontaktflächen soll eine Mehrzahl von Kontaktflächen verstanden werden, die direkt miteinander elektrisch leitend verbunden sind und auf dem gleichen Leistungshalbleiterbauelement angeordnet sind. Weiterhin weist die Schaltungsanordnung mindestens einen Sternpunkt auf. Jede Kontaktfläche und / oder jede elektrisch getrennte Gruppe von Kontaktflächen ist über mindestens ein aktives und / oder passives Bauelement mit diesem Sternpunkt verbunden.

Weiterhin weist die Schaltungsanordnung noch eine Kontaktfläche außerhalb der Leistungshalbleiterbauelemente, beispielhaft auf dem Substrat auf, die mit den Kontaktflächen auf den Leistungshalbleiterbauelementen verbunden ist, dies kann beispielhaft die Emittersammelschiene sein.

Das erfindungsgemäße Verfahren zur Überwachung einer Unterbrechung einer Verbindung zwischen einer Kontaktfläche oder einer Gruppe von Kontaktflächen auf Leistungshalbleiterbauelementen und einer weiteren Kontaktfläche außerhalb des Halbleiterbauelements basiert auf der Detektion einer Potentialdifferenz zwischen dem oder den Sternpunkten und der Kontaktfläche außerhalb des Halbleiterbauelements.

Das Verfahren zur Überwachung einer o.g. Schaltungsanordnung erfolgt beispielhaft mittels einer Überwachungsschaltung bestehend u.a. aus Komparatoren wobei das gewonnene Signal zur Detektion des Ausfalls eines oder einer Mehrzahl elektrisch leitender Verbindungen zu einem Leistungshalbleiterbauelement verwendet wird. Hierbei ist die Schaltungsanordnung zur Überwachung der Emitterverbindung nur dann aktiv, wenn das zugeordnete Leistungshalbleiterbauelement eingeschaltet ist. Ebenso, oder alternativ ist die Schaltungsanordnung zur Überwachung der Senseverbindung nur dann aktiv, wenn das zugeordnete Leistungshalbleiterbauelement ausgeschaltet ist.

Spezielle Ausgestaltungen der erfinderischen Lösungen werden an Hand der Fig. 3 bis 15 erläutert.
- Fig. 3: zeigt eine Schaltungsanordnung zur Anwendung des erfindungsgemäßen Verfahrens.
- Fig. 4: zeigt das elektrische Netzwerk der Schaltungsanordnung nach Fig. 3 ohne Kontaktausfall.
- Fig. 5: zeigt das elektrische Netzwerk der Schaltungsanordnung nach Fig. 3 mit Kontaktausfall.
- Fig. 6: zeigt für einen Ein- und Ausschaltzyklus eines IGBT die Strom- und Spannungsverläufe im Netzwerk nach Fig. 4.
- Fig. 7: zeigt für einen Ein- und Ausschaltzyklus eines IGBT die Strom- und Spannungsverläufe im Netzwerk nach Fig. 5.
- Fig. 8: zeigt das elektrische Netzwerk einer Schaltungsanordnung für vier Leistungshalbleiterbauelemente in zwei Gruppen.
- Fig. 9: zeigt ein Leistungshalbleiterbauelement (IGBT) mit zellulärem Aufbau nach dem Stand der Technik.
- Fig. 10: zeigt eine Schaltungsanordnung als Teil eines Leistungshalbleiterbauelement.
- Fig. 11: zeigt eine Schaltungsanordnung wobei auch zusätzliche Verbindungen zum Sternpunkt überwacht werden.
- Fig. 12: zeigt eine Schaltungsanordnung für vier Leistungshalbleiterbauelemente in zwei Gruppen.
- Fig. 13: zeigt den Aufbau einer Schaltungsanordnung zur Detektion des Ausfalls elektrischer Verbindungen gemäß Fig 12.
- Fig. 14: zeigt ein Diagramm der Detektion einer Ablösung des Emitterbondrahtes.
- Fig. 15: zeigt ein Diagramm der Detektion einer Ablösung eines Sensedrahtes.

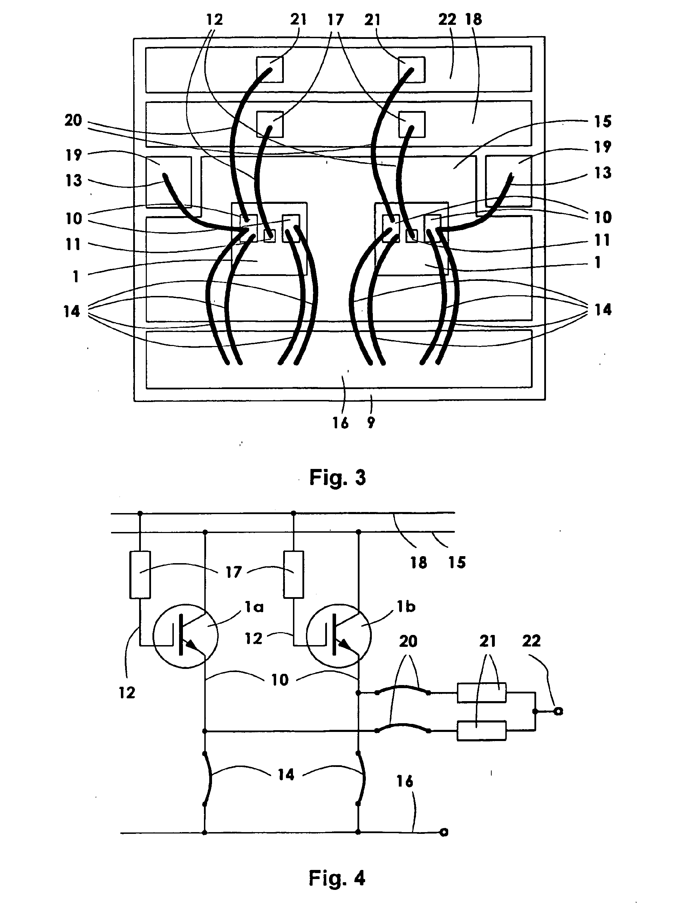

Fig. 3 bis 8 zeigen Schaltungsanordnungen für die erfinderische Lösung anhand eines Leistungshalbleitermoduls vergleichbar denjenigen aus Fig. 1 und 2. Hierbei entsprechen die Gruppen von Kontaktflächen des Anspruchs 1 den Emitterbondpads jedes der einzelnen IGBT Leistungshalbleiterbauelemente. Die Emittersammelschiene entspricht der weiteren Kontaktfläche außerhalb des Halbleiterbauelements.

Fig. 3 zeigt eine gegenüber derjenigen nach Fig. 2 veränderte Schaltungsanordnung. Hierzu wurde ein weiterer kupferkaschierter Bereich (22) auf dem DCB-Substrat (9) angeordnet. Jeder IGBT ist mittels eines zusätzlichen Emitterbonddrahtes (20) und über einen Widerstand (21) mit diesem weiteren kupferkaschierten Bereich (22) verbunden. Diese Widerstände (21) sind dabei auf der von den anderen Kupferflächen isolierten Kupferfläche (22) angeordnet. Die Kupferfläche (22) stellt somit den Sternpunkt einer Sternschaltung dar und wird mit einer Auswerteschaltung verbunden.

Fig. 4 zeigt das elektrische Netzwerk der Schaltungsanordnung nach Fig. 3 ohne Kontaktausfall einer Drahtbondverbindung. Durch die niederohmige Verbindung der Emitter der IGBTs mit dem Sternpunkt besteht im statischen Fall, d.h. in dem Zeitraum in dem der IGBT seinen Schaltzustand nicht ändert, kein signifikanter Potentialunterschied zwischen der Emittersammelschiene (16), dem Hilfsemitteranschluss (19) und dem Sternpunkt des Widerstandsnetzwerks (22).

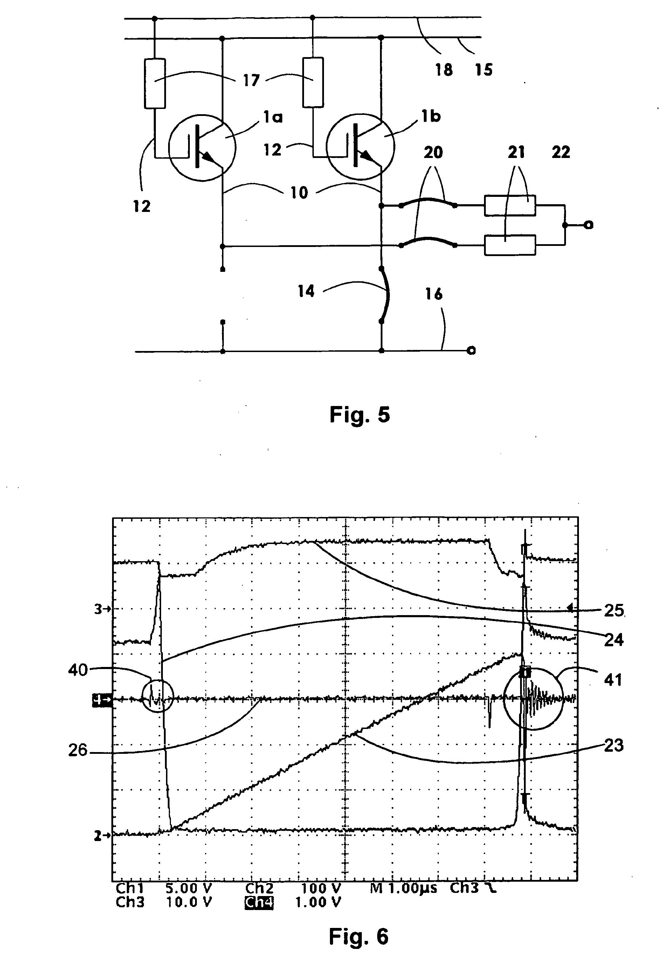

Fig. 5 zeigt das elektrische Netzwerk der Schaltungsanordnung nach Fig. 3 mit Kontaktausfall aller Emitterbonddrähte eines IGBTs. Damit besteht von den Emitterbondpads (10) dieses IGBTs (1a) keine direkte Verbindung zur Emitter-Sammelschiene (16).

Ausschließlich über den zusätzlichen Emitterbonddraht (20) dieses IGBTs (1a), über das Widerstandsnetzwerk, gebildet aus den Widerständen (21) auf der isolierten Kupferfläche (22), den zusätzlichen Emitterbonddraht (20) des anderen IGBTs (1b) sowie dessen Emitterbonddrähten (14) besteht eine leitenden Verbindung zur Emittersammelschiene (16). Dadurch erfährt der Emitter des IGBT (1a), dessen Bonddrähte sich gelöst haben, eine Stromgegenkopplung über das Widerstandsnetzwerk der Widerstände (21) auf der isolierten Kupferfläche (22). Diese Gegenkopplung begrenzt einerseits den Strom durch den fehlerbehafteten IGBT, führt aber auch zu Spannungsabfällen über den Widerständen (21).

Eine Detektion kann nun dadurch erfolgen, dass der Potentialunterschied zwischen dem Sternpunkt (22) und der Emittersammelschiene (16) oder dem Hilfsemitteranschluss (19) ausgewertet wird.

Fig. 6 zeigt für einen Ein- und Ausschaltzyklus eines IGBT die Strom- und Spannungsverläufe im Netzwerk nach Fig. 4. Dargestellt sind die zeitlichen Verläufe des Stromes durch die beiden IGBTs (23), der Spannung über den IGBTs (24), der Spannung am Gate der IGBTs (25) sowie der Spannung am Sternpunkt (26). Dabei steigt der Laststrom (23) von Null beginnend bis zum Abschalten der IGBTs auf etwa 20A. Abgesehen von kurzen Impulsen während der Schaltflanken (40,41) ist die Spannung (26) am Sternpunkt (22) sehr gering.

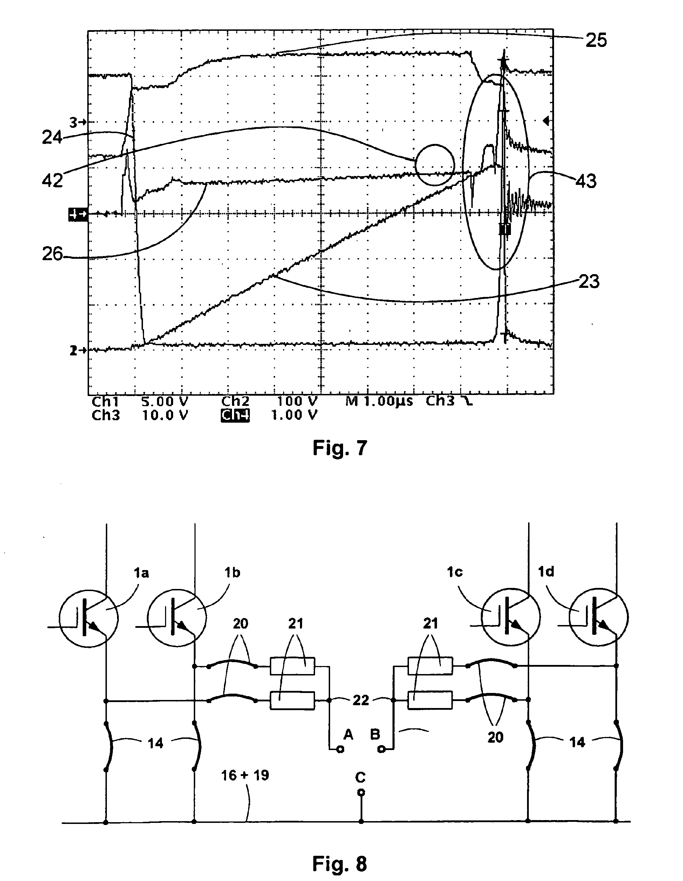

Fig. 7 zeigt für einen Ein- und Ausschaltzyklus eines IGBT die Strom- und Spannungsverläufe im Netzwerk nach Fig. 5. Im Vergleich zu Fig. 6 ist der unterschiedliche Verlauf der Spannung (26) am Sternpunkt während des gesamten dargestellten Zeitintervalls zu erkennen. Beispielsweise steigt die Spannung im eingeschalteten Zustand hier bis auf Werte von 900mV (42). Auch während der Abschaltverzögerungszeit ist ein sehr deutlicher Anstieg der Spannung am Sternpunkt (26) zu erkennen (43).

Je größer die Anzahl an parallel geschalteten IGBTs ist, desto kleiner und somit schwerer auswertbar wird das elektrische Signal am Sternpunkt (22). Dies kann verbessert werden indem das entnommene Signal einer Integratorschaltung zugeführt wird, was zur Steigerung der Störsicherheit und damit der sicheren Detektion führt.

Weiterhin kann die Sternschaltung mit Dioden gebildet werden. Dann ist das Signal am Sternpunkt unabhängig von der Anzahl der parallelgeschalteten Bauelemente. In diesem Fall wäre es vorteilhaft einen Stromfluss vom Sternpunkt zur Auswerteschaltung zu detektieren.

Fig. 8 zeigt das elektrische Netzwerk einer Schaltungsanordnung für vier Leistungsbauelemente in zwei Gruppen, wobei eine Mehrzahl, hier zwei, Sternschaltungen ausgebildet sind für vier Leistungsbauelemente (1a, 1b, 1c, 1d). Die Auskopplung des Signals kann einerseits analog Fig. 5 zwischen den Punkten A und C bzw. B und C erfolgen. Bei symmetrischem Aufbau ist es auch vorteilhaft das Signal zwischen den Punkten A und B zu detektieren und auszuwerten.

Die bisher genannten Ausgestaltung der Schaltungsanordnung für das erfinderische Verfahren weisen die Vorteile auf, dass keinerlei Änderungen der Leistungshalbleiterbauelemente, sondern lediglich geringfügiger Änderungen der Aufbau- und Verbindungstechnik bedarf sowie einer relativ einfachen Auswerteschaltung, die beispielsweise ergänzender Bestandteil der Ansteuer- und Überwachungsschaltung des Leistungshalbleitermoduls ist.

Leistungshalbleiterbauelemente nach dem Stand der Technik, wie beispielsweise Leistungs-Bipolartransistoren, IGBTs, MOS- Leistungstransistoren und Thyristoren sind überwiegend zellulär aufgebaut. Unter zellulärem Aufbau ist dabei zu verstehen, dass Dotiergebiete oder Teilstrukturen mit jeweils gleicher elektrischer Funktion mindestens zweifach als räumlich getrennte Anordnungen innerhalb des Leistungsbauelements ausgebildet werden. Im Falle eines Bipolartransistors können dies beispielsweise Emitterdotiergebiete sein, die als Streifen, Vierecke, Sechsecke etc. mehrfach im Basisdotiergebiet angeordnet sind. Im Falle eines IGBTs wird beispielsweise die gesamte MOS- Struktur mehrfach innerhalb des Substratgebiets ausgebildet.

Kennzeichnend für alle diese Strukturen ist, dass die Haupt- und Steuerelektroden der zellulären Elemente mittels elektrisch leitfähiger Verbindungen miteinander verbunden werden. Im Falle eines IGBTs sind beispielsweise alle Emitter-/Bulkgebiete, Kollektorgebiete und Gates durch eine jeweilige Metallisierungsschicht auf dem IGBT verbunden. Ist dies nicht der Fall, erfolgt die Verbindung über Bonddrähte.

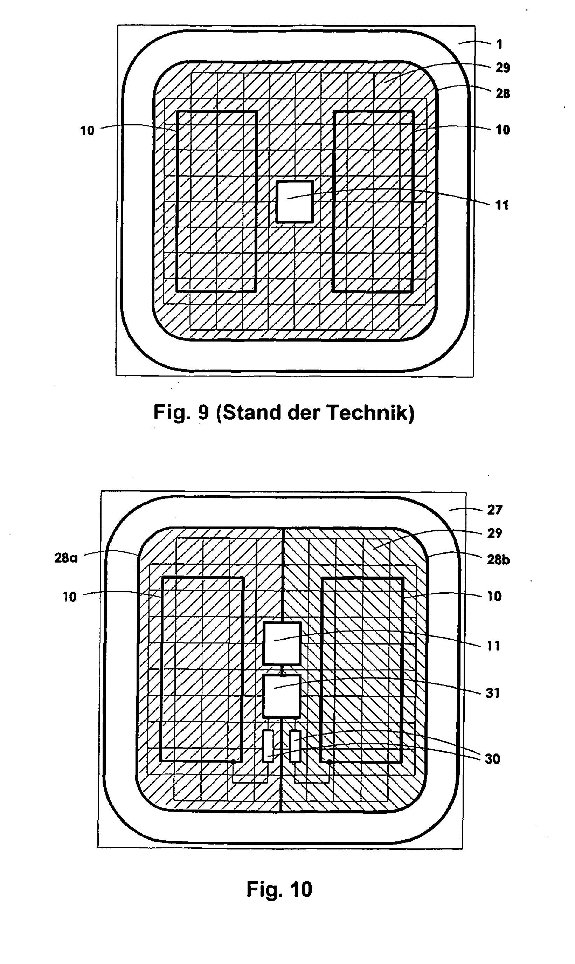

Fig. 9 zeigt ein Leistungshalbleiterbauelement (IGBT) (1) mit zellulärem Aufbau nach dem Stand der Technik in Draufsicht. Dargestellt ist schematisch das Emittermetallisierungsgebiet (28), die IGBT- Zellen (29), die Emitterbondpads (10) und das Gatebondpad (11).

Fig. 10 zeigt eine Schaltungsanordnung, wobei die Kontaktflächen den beiden Emitterbondpads dieses IGBTs entsprechen. Eine optionale zusätzliche Kontaktfläche auf dem IGBT entspricht dem Sternpunkt, der mit der Auswerteschaltung verbunden wird. Die Emitterbondpads werden wie oben beschrieben mit der Emittersammelschiene als weitere Kontaktfläche außerhalb des Halbleiterbauelements verbunden.

Der IGBT (27) ist weist ein in der Formgebung verändertes Emittermetallisierungsgebiet (28a, 28b) auf. Das Emittermetallisierungsgebiet ist hierzu in zwei voneinander elektrisch getrennte Teilgebiete der Emittermetallisierung (28a, 28b) aufgeteilt. Eine Aufteilung in mehr als zwei Teilgebiete ist ebenso in entsprechender Weise möglich. An jedes Teilgebiet der Emittermetallisierung (28a, 28b) wird nur ein bestimmter Teil der IGBT-Zellen (29) angeschlossen.

Bei dieser Ausgestaltung der Schaltungsanordnung kann mit einer Anordnung nach Fig. 3 der Kontaktverlust jedes elektrisch getrennten Emitterbondpads detektiert werden.

Weitere Vorteile ergeben sich, wenn die aktiven oder passiven elektronischen Bauelemente der Sternschaltung in das Leistungshalbleiterbauelement integriert werden. Beispielsweise sind im Falle eines IGBTs Widerstände (30) oder Dioden mittels dotierten Polysilizium-Gebieten realisierbar. Jedes Teilgebiet der Emittermetallisierung (28a, 28b) wird nun über je ein integriertes aktives oder passives elektronisches Bauelement (30) mit einer zusätzlichen weiteren Kontaktfläche (31) auf dem IGBT verbunden, die von den übrigen Metallisierungsgebieten des IGBT elektrisch getrennt ist. Analog zur Verfahrensweise in Fig. 3 wird nun die weitere Kontaktfläche (31) mit der Auswerteschaltung verbunden. Das Abheben der Bonddrähte von einem Emitterbondpad führt analog zu Fig. 5 zu Spannungsabfällen über den integrierten Widerständen (30) im IGBT. Die Detektion kann beispielsweise wiederum dadurch erfolgen, dass der Potentialunterschied zwischen der weiteren Kontaktfläche (31) und der Emittersammelschiene (16) oder dem Hilfsemitteranschluss (19) ausgewertet wird.

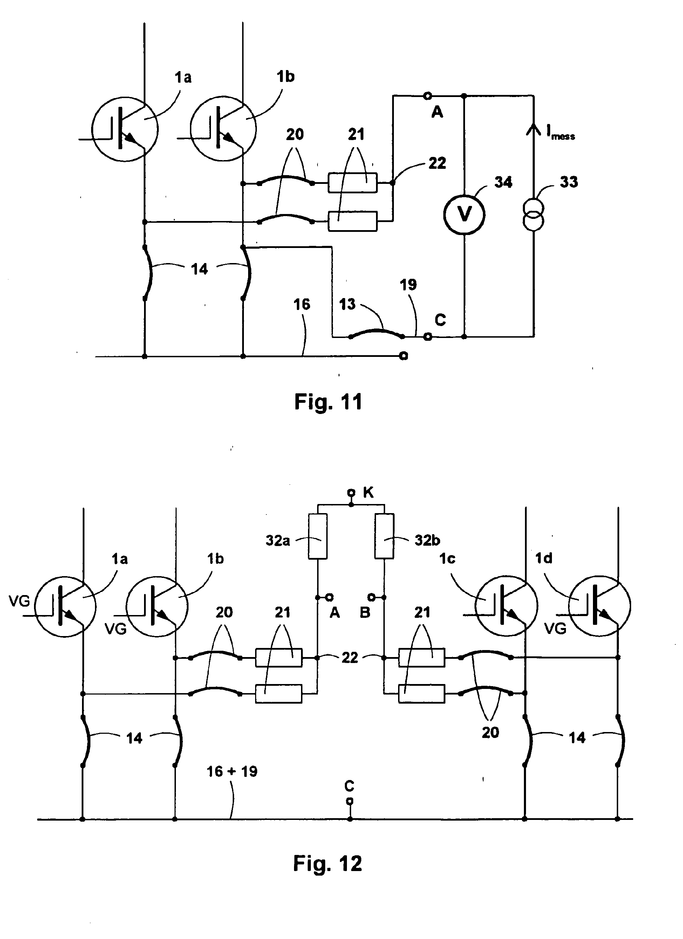

Fig. 11 zeigt eine weitere Anordnung für zwei Leistungshalbleiterbauelemente, beispielhaft für IGBTs. Die korrekte Funktion der zusätzlichen Emitterbonddrähte (20) und des Hilfsemitterbonddrahts (13) kann hierbei ermittelt werden, indem der Widerstandswert zwischen den Punkten A und C mit einer entsprechenden Messschaltung (33, 34) ermittelt wird.

Fig. 12 zeigt eine Schaltungsanordnung für vier Leistungshalbleiterbauelemente, beispielhaft für IGBTs, mit zwei Sternschaltungen, mit der ebenfalls das Vorhandensein einer leitfähigen Verbindung vom Sternpunkt (22) der Sternschaltungen zu den Kontaktflächen der Leistungshalbleiterbauelemente und zur Auswerteschaltung überwacht werden kann. VG bezeichnet hier das Gateansteuersignal vom Treiber.

Die Detektion ist hier auf sehr einfache Weise möglich, da das Prinzip einer Messbrücke angewandt werden kann. Die Messbrücke wird durch die beiden Widerstände am Punkt K (32a, 32b) und den beiden Gruppen parallelgeschalteter Widerständen (21) an den Emittern der IGBTs gebildet. Zwischen den Punkten K und C wird ein elektrisches Signal, z.B. eine Spannung, angelegt. Sowohl der Ausfall der Emitterbonddrähte (14) bzw. der zusätzlichen Emitter-Bonddrähte (20) sowie der Verbindung zwischen Sternpunkt (22) und Auswerteschaltung führen zu einem Verlust des Gleichgewichts der Brücke, was als elektrisches Signal beispielsweise zwischen der Punkten A und B detektiert werden kann. Analog kann auch der Verlust des Hilfsemitterbonddrahtes (13) überwacht werden, wenn er wie in Fig.11 separat herausgeführt ist.

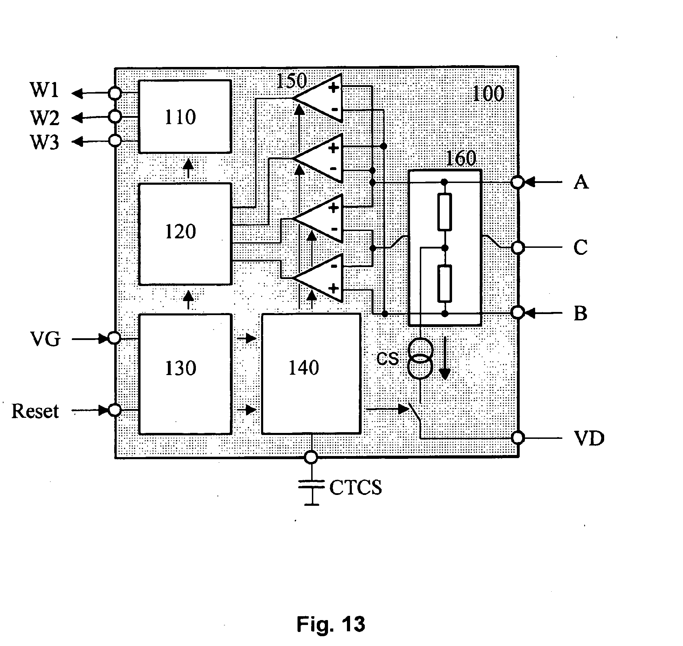

Fig. 13 zeigt den Aufbau einer Schaltungsanordnung (100) zur Detektion des Ausfalls elektrischer Verbindungen gemäß Fig 12. Die Eingänge der Schaltungsanordnung sind entsprechend den Kontaktpunkten der Fig. 12 bezeichnet. Die Schaltungsanordnung (100) besteht aus einer Fehlerverarbeitungseinheit (110), einem Fehlerspeicher (120), einem Eingangsinterface (130) mit Resetmöglichkeit, einem Widerstandsnetzwerk (160) und einer Steuereinheit (140) zur Ansteurung einer Stromquelle (CS) sowie einer Mehrzahl von Komparatoren (150). Die Schaltungsanordnung weist drei Fehlersignalausgänge (W1, W2, W3), eine Spannungsversorgung (VD), einen extern beschalteten Kondensator (CTCS) sowie Eingänge für die Gateansteuerspannung (VG), den Kontaktpunkt (C) der Emittersammelschiene und die Kontaktpunkte (A, B) zur den Sensedrähten (20) auf.

Das Detektionsverfahren des Ausfalls einer Emitter- oder einer Senseverbindung wird im folgenden beschrieben. Hierzu sind zwei der vier Komparatoren mit den Kontaktpunkten (A) und (B) beschaltet, wobei die Beschaltung des zweiten Komparators spiegelsymmetrisch zum ersten ist. Der dritte Komparator ist mit den Kontaktpunkten (A) und (C), sowie der vierte mit den Kontaktpunkte (B) und (C) beschaltet. Somit ist die Überwachung jeder einzelnen der oben genannten Verbindungen möglich.

Die Überwachung einer Emitterverbindung ist nur sinnvoll, wenn der entsprechende IGBT sich im leitenden Zustand befindet, dies wird durch die Steuereinheit (140) gewährleistet. Sie schaltet die Überwachung erst nach dem Einschaltvorgang des IGBTs. Die hierfür notwendige Steuergröße wird durch die Gatesteuerspannung, die am Eingang (VG) anliegt, gebildet.

Im Gegensatz hierzu ist die Überwachung einer Senseverbindung nur im nicht leitenden Zustand eines IGBTs sinnvoll, die Information hierüber wird ebenfalls aus dem Eingang (VG) gewonnen. Zur Überwachung wird durch die Steuereinheit (140) die Stromquelle (CS) eingeschaltet. Deren Verbindung mit den Widerständen (160) der Schaltungsanordnung (100) sowie der Widerstände (21, Fig. 12) ergibt eine Wheatstone-Brückenschaltung. Das Ausgangssignal dieser Wheatsonebrücke ist Null solange kein Fehler vorliegt, es weicht von Null ab bei Vorliegen einer Kontaktunterbrechung der Senseverbindung (20). Um die Verlustleistung durch dieses Verfahren gering zu halten wird die Überwachung des Senseverbindungen nicht nach jedem Ausschalten ausgeführt. Die Anzahl der Schaltperioden nach der die Senseverbindung geprüft wird ist einstellbar. Der Kondensator (CTCS) dient zur Einstellung der Pulsweite, in der die Stromquelle (CS) aktiv ist. Die Pulweite kann alternativ auch fest eingestellt sein. Den verschiedenen möglichen Fehlern können über mehrere, hier drei, Fehlerausgänge (W1, W2, W3) spezielle Fehlercodes zugewiesen werden.

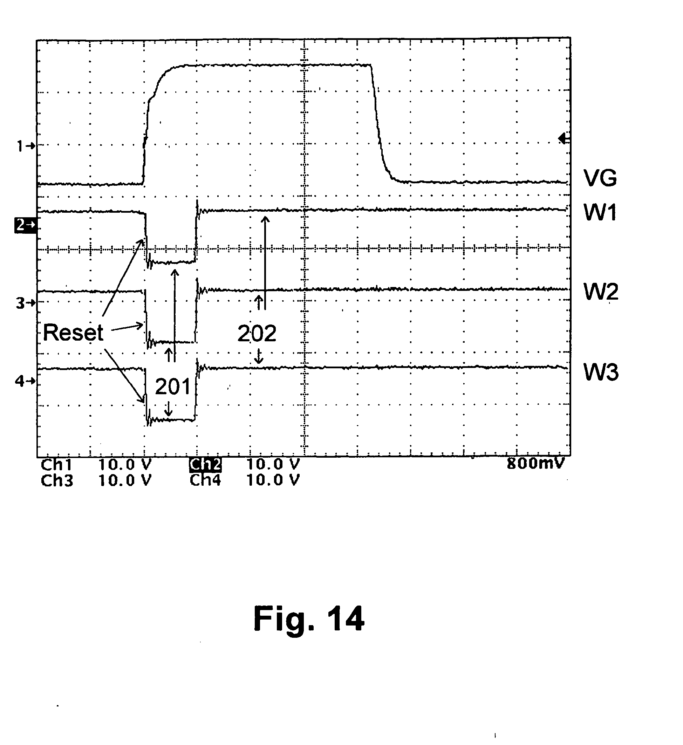

Fig. 14 zeigt ein Diagramm der Detektion einer Ablösung des Emitterbondrahtes. Mit Beginn des Einschaltens des IGBTs wird das Fehlersignal auf LOW zurückgesetzt (201). Die Überwachung beginnt eine definierte Zeitspanne nach dem Einschalten des IGBTs, wozu die Gatesteuerspannung (VG) ausgewertet wird. Die Unterbechung einer Emitterverbindung (202) wird detektiert und angezeigt durch das Anheben aller Pegel der Aussangssignale (W1, W2, W3) von LOW auf HIGH. Dieser Fehler ist somit als "111" codiert.

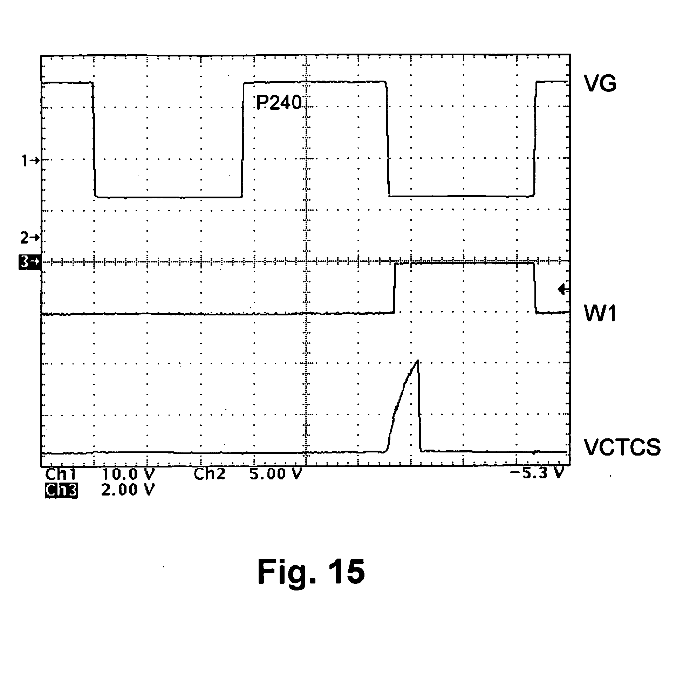

Fig. 15 zeigt ein Diagramm der Detektion einer Ablösung eines Sensedrahtes. Die Überwachung beginnt nach einer eingestellten Anzahl, hier 240 (P240), von Schaltperioden. Nach dem Ausschalten wird die Stromquelle (CS) aktiviert, siehe entsprechende Spannungskurve (VCTCS). Eine unterbrochene Senseverbindung wird beispielhaft detektiert und angezeigt durch die Änderung des Ausgangssignal (W1) von LOW auf HIGH. Dieser Fehler ist somit als "100" codiert.

## Patentansprüche

1. Verfahren zur Überwachung einer Schaltungsanordnung bestehend aus mindestens zwei voneinander elektrisch getrennten Kontaktflächen (10) gleicher Funktionalität oder mindestens zwei voneinander elektrisch getrennten Gruppen von Kontaktflächen (10) gleicher Funktionalität, wobei die Kontaktflächen einer Gruppe elektrisch leitend miteinander verbunden sind, diese Kontaktflächen (10) auf mindestens einem Leistungshalbleiterbauelement (1, 27) angeordnet sind und jede elektrisch getrennte Kontaktfläche oder jede elektrisch getrennte Gruppe von Kontaktflächen über mindestens ein aktives und / oder passives Bauelement (21, 30) mit dem Sternpunkt (22, 31) mindestens einer Sternschaltung elektrisch leitend verbunden ist und alle elektrisch getrennten Kontaktflächen oder alle elektrisch getrennten Gruppen von Kontaktflächen mit mindestens einer weiteren, außerhalb des /der Leistungshalbleiterbauelements/e angeordneten, Kontaktfläche (16, 19) elektrisch leitend verbunden sind und sowohl der Sternpunkt (22,31) als auch die Kontaktflächen (16, 19) zum Zwecke der Potentialauswertung nach außen geführt sind, **dadurch gekennzeichnet, dass** während des Betriebs die Potentialdifferenz zwischen dem oder den Sternpunkten (22, 31) und der weiteren Kontaktfläche (16, 19) außerhalb des Leistungshalbleiterbauelements überwacht wird und das gewonnene Signal zur Detektion des Ausfalls eines oder einer Mehrzahl elektrisch leitender Verbindungen zu einem Leistungshalbleiterbauelement verwendet wird.

2. Verfahren nach Anspruch 1 **dadurch gekennzeichnet, dass** die Potentialdifferenz zwischen dem oder den Sternpunkten (22, 31) und der weiteren Kontaktfläche (16, 19) außerhalb des Leistungshalbleiterbauelements mittels einer Überwachungsschaltung (100) aus Komparatoren (150) überwacht wird und das gewonnene Signale (202) zur Detektion des Ausfalls eines oder einer Mehrzahl elektrisch leitender Verbindungen (14, 20) zu einem Leistungshalbleiterbauelement verwendet wird, wobei die Schaltungsanordnung zur Überwachung einer Emitterverbindung (14) nur nach dem Einschalten des zugeordneten Leistungshalbleiterbauelements aktiv ist und die Schaltungsanordnung zur Überwachung einer Senseverbindung (20) nur nach dem Ausschalten des zugeordneten Leistungshalbleiterbauelements aktiv ist.

3. Verfahren nach Anspruch 2 **dadurch gekennzeichnet, dass** die Senseverbindungen (20) mittels einer Wheatstone- Brückenschaltung überwacht werden, die durch eine Stromquelle (CS) gespeist wird, und ein Ausgangssignal dieser Brückenschaltung ungleich Null nach einer Schwellwertbildung ein Fehlersignal darstellt.

4. Verfahren nach Anspruch 2 **dadurch gekennzeichnet, dass** die Überwachung der Senseverbindungen (20) jeweils nur nach einer Mehrzahl von Schaltperioden des Leistungshalbleiterbauelements durchgeführt wird.

5. Verfahren nach Anspruch 1 **dadurch gekennzeichnet, dass** das oder die Leistungshalbleiterbauelemente (27) IGBT- oder MOSFET-Transistoren sind mit je mindestens zwei elektrisch voneinander getrennten Kontaktflächen (10) und diese Kontaktflächen internen Gruppen von Transistorzellen (29) zugeordnet sind und diese Kontaktflächen mittels mindestens je einem in den Transistor (27) integrierten aktiven und / oder passiven Bauelement (30) mit einem auf dem Transistor (27) angeordneten Sternpunkt (31) verbunden sind.

6. Verfahren nach Anspruch 1 **dadurch gekennzeichnet, dass** eine Mehrzahl von Sternschaltungen zusammen mit weiteren passiven und / oder aktiven Bauelementen eine Widerstands- Brückenschaltung bestehend aus Widerständen (21, 32) bilden.

## Claims

1. A method for monitoring a circuit arrangement consisting of at least two mutually electrically separated contact surfaces (10) with the same functionality or at least two mutually electrically separated groups of contact surfaces (10) with the same functionality, wherein the contact surfaces of a group are electrically conductively connected with one another, these contact surfaces (10) are arranged on at least one power semiconductor module (1, 27) and each electrically separated contact surface or each electrically separated group of contact surfaces is electrically conductively connected to the neutral point (22, 31) of at least one star connection via at least one active and/or passive component (21, 30) and all electrically separated contact surfaces or all electrically separated groups of contact surfaces are electrically conductively connected to at least one further contact surface (16, 19) which is arranged externally to the power semiconductor module(s) and both the neutral point (22, 31) and the contact surfaces (16, 19) are led externally for the purpose of potential evaluation, **characterised in that**, during operation, the potential difference between the neutral point(s) (22, 31) and the further contact surface (16, 19) external to the power semiconductor module is monitored and the signal obtained is used for detecting the failure of a or a plurality of electrically conductive connection(s) to a power semiconductor module.

2. The method according to Claim 1, **characterised in that** the potential difference between the neutral point(s) (22, 31) and the further contact surface (16, 19) external to the power semiconductor module is monitored by means of a monitoring circuit (100) made up of comparators (150) and the signal (202) obtained is used for detecting the failure of a or a plurality of electrically conductive connection(s) (14, 20) to a power semiconductor module, wherein the circuit arrangement for monitoring an emitter connection (14) is only active after the switching on of the assigned power semiconductor module and the circuit arrangement for monitoring a sense connection (20) is only active after the switching off of the assigned power semiconductor module.

3. The method according to Claim 2, **characterised in that** the sense connections (20) are monitored by means of a Wheatstone bridge circuit, which is fed by means of a current source (CS), and an output signal of this bridge circuit, which is not equal to zero after the formation of a threshold value, constitutes an error signal.

4. The method according to Claim 2, **characterised in that** the monitoring of the sense connections (20) is in each case only carried out after a plurality of switching periods of the power semiconductor module.

5. The method according to Claim 1, **characterised in that** the power semiconductor module(s) (27) are IGBT or MOSFET transistors each with at least two mutually electrically separated contact surfaces (10) and these contact surfaces are assigned to internal groups of transistor cells (29) and these contact surfaces are connected to a neutral point (31), which is arranged on the transistor (27), by means of at least one active and/or passive component (30) integrated into the transistor (27).

6. The method according to Claim 1, **characterised in that** a plurality of star connections together with further passive and/or active components form a resistance bridge circuit consisting of resistors (21, 32).

## Revendications

1. Procédé de surveillance d'un agencement de circuit composé d'au moins deux surfaces de contact (10) aux fonctionnalités identiques, électriquement séparées l'une de l'autre, ou d'au moins deux groupes de surfaces de contact (10) aux fonctionnalités identiques, électriquement séparés l'un de l'autre, les surfaces de contact d'un groupe étant reliées ensemble de manière électroconductrice, dans lequel ces surfaces de contact (10) sont disposées sur au moins un composant semiconducteur de puissance (1, 27), dans lequel chaque surface de contact électriquement séparée ou chaque groupe de surfaces de contact électriquement séparé est relié de manière électroconductrice, via au moins un composant (21, 30) actif et/ou passif, avec le point neutre (22, 31) d'au moins un circuit en étoile, dans lequel toutes les surfaces de contact électriquement séparées ou tous les groupes de surfaces de contact électriquement séparés sont reliés de manière électroconductrice à au moins une autre surface de contact (16, 19) disposée en dehors du ou des composants semiconducteurs de puissance et dans lequel aussi bien le point neutre (22, 31) que les surfaces de contact (16, 19) sont câblés vers l'extérieur dans le but d'examiner leur potentiel, **caractérisé en ce que**, pendant le service, la différence de potentiel est surveillée entre le ou les points neutres (22, 31) et l'autre surface de contact (16, 19) en dehors du composant semiconducteur de puissance et **en ce que** le signal obtenu est utilisé pour détecter la défaillance d'une ou plusieurs liaisons électroconductrices vers un composant semiconducteur de puissance.

2. Procédé selon la revendication 1, **caractérisé en ce que** la différence de potentiel entre le ou les points neutres (22, 31) et l'autre surface de contact (16, 19) en dehors du composant semiconducteur de puissance est surveillée à l'aide d'un circuit de surveillance (100) fait de comparateurs (150) et **en ce que** le signal obtenu (202) est utilisé pour détecter la défaillance d'une ou plusieurs liaisons électroconductrices (14, 20) vers un composant semiconducteur de puissance, dans lequel l'agencement de circuit destiné à la surveillance d'une liaison d'émetteur (14) n'est activé qu'après la mise en service du composant semiconducteur de puissance correspondant et l'agencement de circuit destiné à la surveillance d'une liaison de détection (20) n'est activé qu'après la coupure du composant semiconducteur de puissance correspondant.

3. Procédé selon la revendication 2, **caractérisé en ce que** les liaisons de détection (20) sont surveillées à l'aide d'un circuit en pont de Wheatstone qui est alimenté par une source de courant (CS) et **en ce qu'**un signal de sortie de ce circuit en pont différent de zéro après la formation d'une valeur de seuil constitue un signal d'erreur.

4. Procédé selon la revendication 2, **caractérisé en ce que** la surveillance des liaisons de détection (20) n'est exécutée qu'après une pluralité de périodes de commutation du composant semiconducteur de puissance.

5. Procédé selon la revendication 1, **caractérisé en ce que** le ou les composants semiconducteurs de puissance (27) sont des transistors IGBT ou MOSFET, avec chacun au moins deux surfaces de contact (10) électriquement séparées l'une de l'autre et **en ce que** ces surfaces de contact sont reliées chacune à un point neutre (31) disposé sur le transistor (27) au moyen d'au moins un composant actif et/ou passif (30) intégré dans le transistor (27).

6. Procédé selon la revendication 1, **caractérisé en ce qu'**une pluralité de circuits en étoile forment ensemble, avec d'autres composants passifs et/ou actifs, un circuit en pont de résistances, formé de résistances (21, 32).
